# EUROPÄISCHE PATENTSCHRIFT

(11) **EP 1 692 766 B1**
(45) Veröffentlichungstag und Bekanntmachung des Hinweises auf die Patenterteilung: **09.07.2008**
(21) Anmeldenummer: 04802920.1
(22) Anmeldetag: 10.12.2004
(51) Int. Cl.: H03K 17/16

(54) **VERFAHREN UND SCHALTUNGSANORDNUNG ZUR ANSTEUERUNG EINES LASTELEMENTS MITTELS EINES ELEKTRONISCHEN SCHALTELEMENTS IM LASTSTROMKREIS**
METHOD AND CIRCUIT ARRANGEMENT FOR CONTROLLING A LOAD ELEMENT BY MEANS OF AN ELECTRONIC SWITCHING ELEMENT IN A LOAD-CURRENT CIRCUIT
PROCEDE ET DISPOSITIF DE COMMUTATION POUR COMMANDER UN ELEMENT DE CHARGE AU MOYEN D'UN ELEMENT DE COMMUTATION ELECTRONIQUE DANS LE CIRCUIT ELECTRIQUE DE CHARGE

(30) Priorität: 11.12.2003 DE 10358276
(43) Veröffentlichungstag der Anmeldung: 23.08.2006
(73) Patentinhaber: Conti Temic microelectronic GmbH, 90411 Nürnberg (DE)
(72) Erfinder: JOOS, Uli, 88149 Nonnenhorn (DE); LENK, Armin, 88356 Ostrach-Magenbuch (DE)
(74) Vertreter: Pröll, Jürgen
(86) Internationale Anmeldenummer: PCT/DE2004/002715
(87) Internationale Veröffentlichungsnummer: WO 2005/057788

(56) Entgegenhaltungen:
- EP-A- 0 340 731
- US-A- 6 094 086
- US-A1- 2001 040 470

## Beschreibung

Die Erfindung betrifft ein Verfahren zur Ansteuerung eines Lastelements gemäß dem Oberbegriff des Anspruchs 1.

Die Ansteuerung insbesondere auch vieler im wesentlichen ohmscher elektrischer Lasten im Kfz (zB. Lampen, Heizwendeln, ...) erfolgt mittels Pulsweitenmodulation (PWM). Hierbei kann die an die Last abgegebene Leistung geregelt oder gesteuert werden, wobei die Verluste in der Ansteuerelektronik durch den Schaltbetrieb klein gehalten werden können.

Bei der pulsweitenmodulierten Ansteuerung von Lasten im KfZ werden jedoch über die Batterie- und Lastzuleitungen elektromagnetische Felder emittiert, die den Rundfunkempfang im Fahrzeug stören können.

Deshalb wurden hierzu in verschiedenen Normen (IEC, ISO, CISPR) Grenzwerte festgelegt, die die Beeinflussung des Rundfunkempfängers in den entsprechenden Spektren auf ein erträgliches Maß reduzieren.

Die Unterdrückung der Wechselströme auf den Zuleitungen erfolgt gewöhnlich mit Tiefpaßfiltern (LC) in den Eingangsleitungen. Die Größe und auch die Kosten der Filter richten sich nach Strombelastbarkeit, benötigte Dämpfung, Güte und Grenzfrequenz. Die PWM wird in KfZ-Steuergeräten normalerweise über für eine Mehrzahl von Lastelementen durch in den Microcontroller integrierte Timer-Module erzeugt, wobei alle PWM-Ausgänge zum selben Zeitpunkt einschalten und je nach PWM-Tastverhältnis zu verschiedenen Zeitpunkten ausschalten.

Diese Verfahren hat den Nachteil, daß dem Netz ein sehr großer Wechselstrom entnommen wird und deshalb hohe Anforderungen an die verwendeten Filter, insbesondere die Speicherkondensatoren, zu stellen sind.

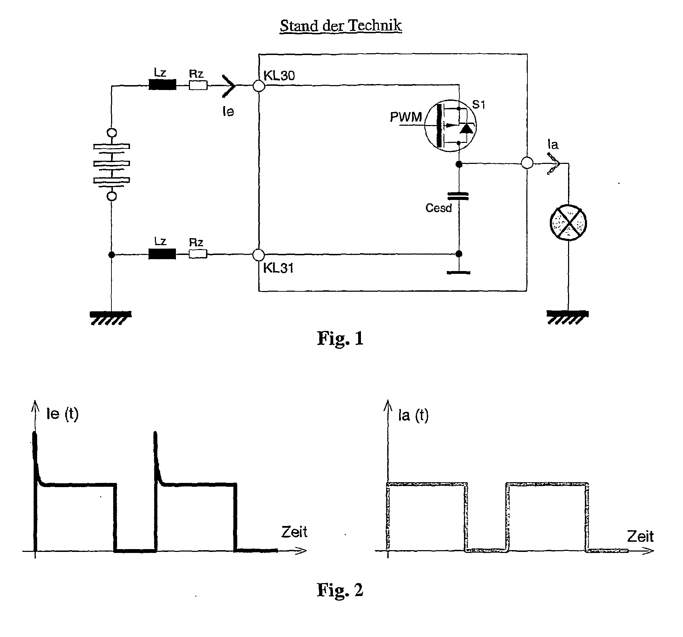

Fig. 1 zeigt schematisch eine Ersatzschaltung für den Schalter im PWM-Betrieb. Hierbei wird eine beliebige Last (hier beispielsweise eine Glühwendellampe) über einen Schalter (z.B. ein N-MOSFET oder ein Bipolar-Transistor) mittels des Signals pulsweitenmoduliert im Bereich einer Schaltfrequenz von 25Hz...500Hz angesteuert.. Je nach Schaltzustand des Schalters wird dem Netz dabei Strom entnommen oder nicht. Der zeitliche Verlauf des Eingangs- und Ausgangsstroms ist in der folgenden Fig. 2 dargestellt.

Die dabei auftretenden Stromgradienten erzeugen dabei hochfrequente Stromanteile auf den Zuleitungen, die ihrerseits Störungen in den Rundfunkfrequenzen LW, MW und KW (150kHz bis 10 MHz) verursachen.

Herkömmliche Verfahren bedämpfen die hochfrequenten Wechselströme auf den Zuleitungen mit Filtern in den Eingangs- und Ausgangsleitungen wie in den folgenden Bildern 3 bis 5 dargestellt.

Der Nachteil der Filter ist jedoch ihr hoher Kosten und Platzbedarf, der die Elektronik verteuert und nicht miniaturisiert (Integration in Silizium) werden kann.

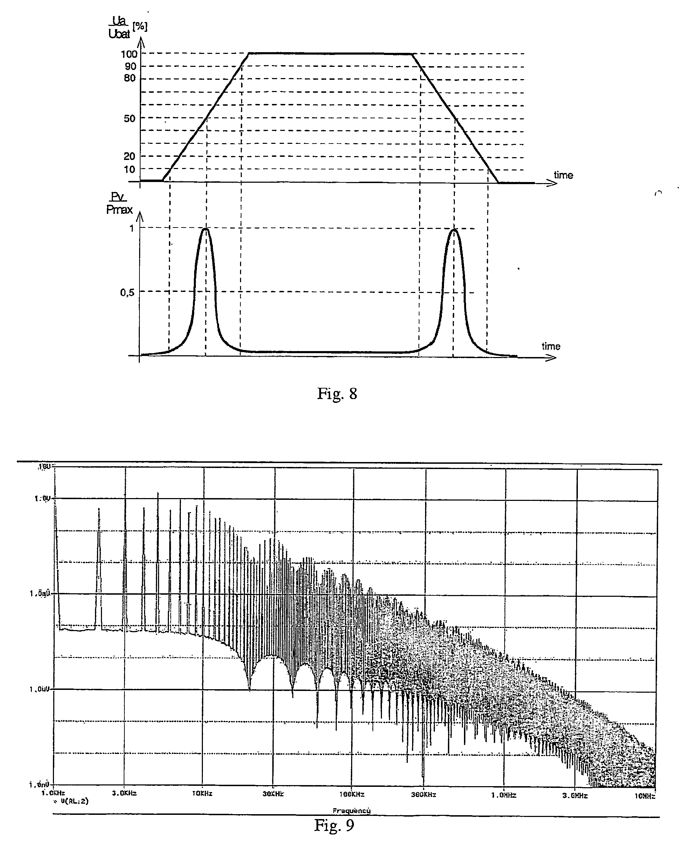

Ein weitere Möglichkeit zur Reduktion der elektromagnetischen Abstrahlung ist die Reduktion der Schaltgeschwindigkeit im Schalter, wodurch die hochfrequenten Stromanteile auf das notwendige Maß reduziert werden können. Dabei nehmen allerdings die unerwünschten, weil die Elektronik aufheizenden, Schaltverluste mit abnehmender Schaltgeschwindigkeit zu. Fig. 8 skizziert den Schaltverlauf anhand der Ausgangsspannung mit einer sogenannten "constant slew rate" sowie die Verluste, die dabei im sogenannten aktiven Bereich der elektronischen Schalter auftreten. Insbesondere für induktive Lastelemente ist es bereits bekannt, die Steigung der Schaltflanke in Abhängigkeit von der Zeit über den Schaltverlauf zu verändern, um die Verlustleistung zu reduzieren. Dabei wird aber die Schaltflanke nach zeitlich fest vorgegebenen Zeitpunkten verändert. Bei der DE 44 13 546 A1 wird darüber hinaus bei einer induktiven Last mit einem Freilaufkreis die Schaltflanke in Abhängigkeit vom Schaltzustand des Schaltelements verändert. Diese Vorgehensweise ist auch aus US 2001/0040470 bekannt.

Aufgabe der Erfindung ist es, ein Verfahren der eingangs genannten Art insbesondere auch für ohmsche Lastelemente vorzustellen und die bisherigen Verfahren hinsichtlich der Schaltzeit, Verlustleistung und Störabstrahlung zu verbessern, also beispielsweise die Störungen weiter zu verringern, ohne die Verlustleistung zu erhöhen oder bei gleichbleibender Störabstrahlung die Schaltzeit und Verlustleistung zu reduzieren. Diese Aufgabe wird durch die Merkmale des Anspruchs 1 gelöst. Vorteilhafte Weiterbildungen sind den Unteransprüchen zu entnehmen.

Die Erfindung basiert auf der Erkenntnis, daß es für die positive Beeinflussung des hochfrequenten Störspektrums ausreicht, die Steigung in dem für die Verlustleistung unkritischen Bereich am Anfang und Ende des Schaltvorgangs herabzusetzen, d.h. dort mit einer Verzögerung zu arbeiten, die unterhalb der im aktiven Bereich liegt, und andererseits in dem aktiven bereich mit hoher Verlustleistung eine hohe Steigung, also eine kurze Schaltzeit zu nutzen.

Dieses Verfahren ist insbesondere auf die Ansteuerung eines im wesentlichen ohmschen Lastelements, also mit vernachlässigbarem induktiven oder kapazitiven Anteil ausgerichtet. Mittels eines elektronischen Schaltelements im Laststromkreis wird die Spannung am Lastelement mit einer maximal vorgegebenen Steigung gesteuert, indem während des Schaltvorgangs mehrfach, vorzugsweise kontinuierlich die momentan auftretende Verlustleistung oder eine dazu abhängige Größe erfasst und die momentane Steigung in Abhängigkeit davon gesteuert wird.

Dies erfolgt vorzugsweise derart, dass während des Schaltvorgangs das momentane Verhältnis aus Spannung am Lastelement zur Versorgungsspannung (Ua/Ubat) erfasst wird, wobei zumindest für bestimmte Wertebereiche des Verhältnisses (Ua/Ubat) zugeordnete Steigungswerte vorgegeben werden und die Steigung während des Schaltvorgangs entsprechend angepasst wird.

Die Steigungswerte können beispielsweise in Form bestimmter Stromwerte vorgegeben werden, die einem Gate eines MOSFET-Transistors als elektronisches Schaltmittel zugeführt werden.

Die vorliegende Erfindung beeinflußt die Flanken im Schaltelement in der Art, daß die Anstiegsgeschwindigkeit
- hoch ist in dem Bereich, in der die Verlustleitung hoch ist
- klein ist in dem Bereich, in der die Verlustleitung klein ist

Es ergibt sich ein Verfahren zur Ansteuerung eines Lastelements mittels eines elektronischen Schaltelements im Laststromkreis, wobei der Schaltvorgang in zumindest drei Phasen erfolgt. In der ersten Phase wird die Ausgangsspannung bis zu einem ersten vorgegebenen Schwellwert (zB. 15%) mit maximal einer ersten Steigung gesteuert, in der anschließenden Phase die Ausgangsspannung bis zu einem zweiten vorgegebenen Schwellwert (zB. 85%) mit maximal einer zweiten Steigung und in einer dritten wiederum anschließenden Phase wieder maximal mit der ersten Steigung gesteuert wird, wobei die zweite Steigung größer ist als die erste Steigung.

Dieses Verfahren kann vorzugsweise durch mehrere Zwischenstufen noch weiter verfeinert werden, derart dass beispielsweise der Schaltvorgang in fünf Phasen erfolgt, wobei
- in der ersten Phase die Ausgangsspannung bis zu einem ersten vorgegebenen Schwellwert (zB. 10%) mit einer ersten Steigung gesteuert wird,
- in der zweiten Phase die Ausgangsspannung bis zu einem zweiten vorgegebenen Schwellwert (zB. 20%) mit einer zweiten Steigung gesteuert wird
- in der dritten Phase die Ausgangsspannung bis zu einem dritten vorgegebenen Schwellwert (zB. 80%) mit einer dritten Steigung gesteuert wird,
- in der vierten Phase die Ausgangsspannung bis zu einem zweiten vorgegebenen Schwellwert (zB. 90%) mit der zweiten Steigung gesteuert wird
- in der abschließenden fünften Phase die Ausgangsspannung bis zur Versorgungsspannung mit der ersten Steigung gesteuert wird
- wobei die dritte Steigung größer ist als die zweite Steigung und diese wiederum größer ist als die erste Steigung.

Die Erfindung wird nachfolgend anhand von Ausführungsbeispielen und Figuren näher erläutert. Es zeigen:
- Fig. 1: Ersatzschaltbild einer PWM-Ansteuerung gemäß dem stand der Technik
- Fig. 2: Schaltflanken zu Fig. 1

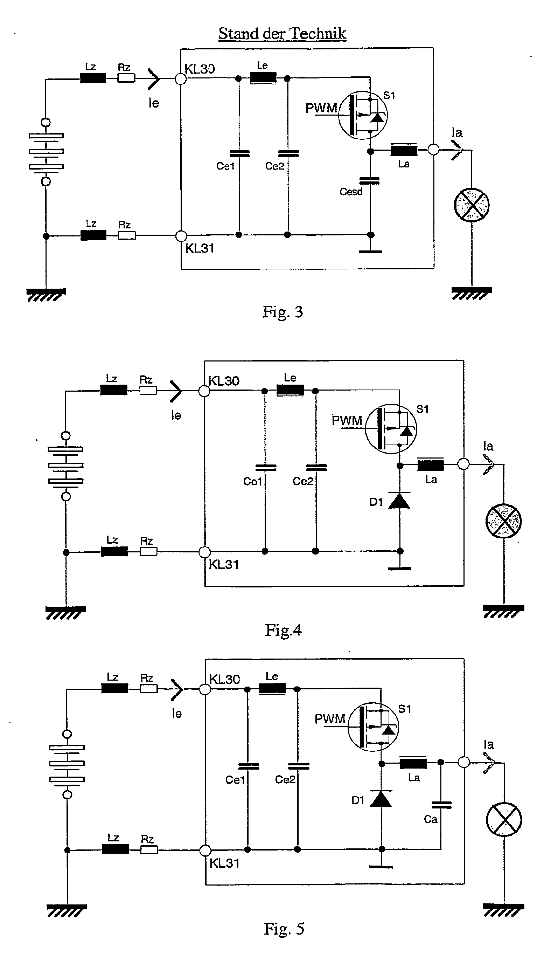

- Fig. 3-5: Filterschaltungen zur Dämpfung der Störungen gemäß dem Stand der Technik
- Fig. 6-7: Ersatzschaltbild einer Schaltungsanordnung mit Flankensteuerung in Abhängigkeit von der Spannung am Lastelement und vorzugsweise auch der Spannung am Steuereingang für MosFET- bzw. Bipolartransistorschaltmittel
- Fig. 8,9: Schaltverhalten, Verlustleistung und Frequenzspektrum für eine Ansteuerung mit einer konstanten Steigung
- Fig. 10,11: Schaltverhalten, Verlustleistung und Frequenzspektrum für eine erfindungsgemäße Ansteuerung mit einer Steigung in Abhängigkeit von der Verlustleistung, also einer stärkeren Verzögerung = geringeren Steigung am Anfang und Ende des Übergangsbereichs, hier durch abgerundete Übergänge erkennbar, wobei die Verlustleistung annähernd gleich bleibt, jedoch das Frequenzspektrum deutlich geringere Störungen im HF-Bereich aufweist
- Fig. 12: Ansteuerung in einem mehrstufigen stromgesteuerten Verfahren

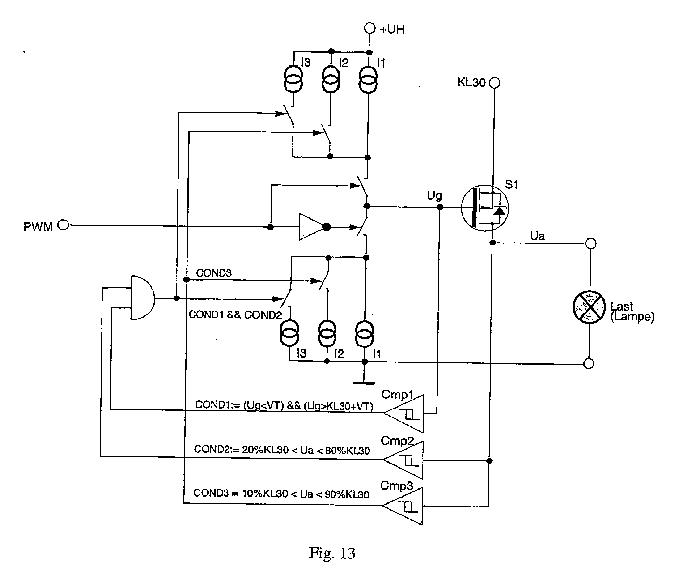

- Fig. 13: Schaltungsanordnung zur Durchführung des Verfahrens nach Fig. 12
- Fig. 14: relative Verlustleistung in Abhängigkeit von der Ausgangsspannung

Die vorliegende Erfindung beruht auf einer weiteren aktiven Beeinflussung der Schaltflanken der Schalteinrichtung dergestalt, dass im mittleren Bereich des Schaltverlaufs, in welchem die Verlustleistungen auftreten, eine hohe Steigung verwendet und damit ein schnelles Überbrücken dieses Bereichs erreicht wird, während in den Bereichen am Anfang und Ende des Schaltvorgangs, in denen kaum Verlustleistung anfällt, die Schaltflanke deutlich langsamer verläuft. Der Bereich der Steigung ist dabei als betragsmäßiger Gradient des Verlaufs der Ausgangsspannung zu verstehen und der Verlauf beim Ausschalten entsprechend mit negativem Vorzeichen in mathematischem Sinne versehen.

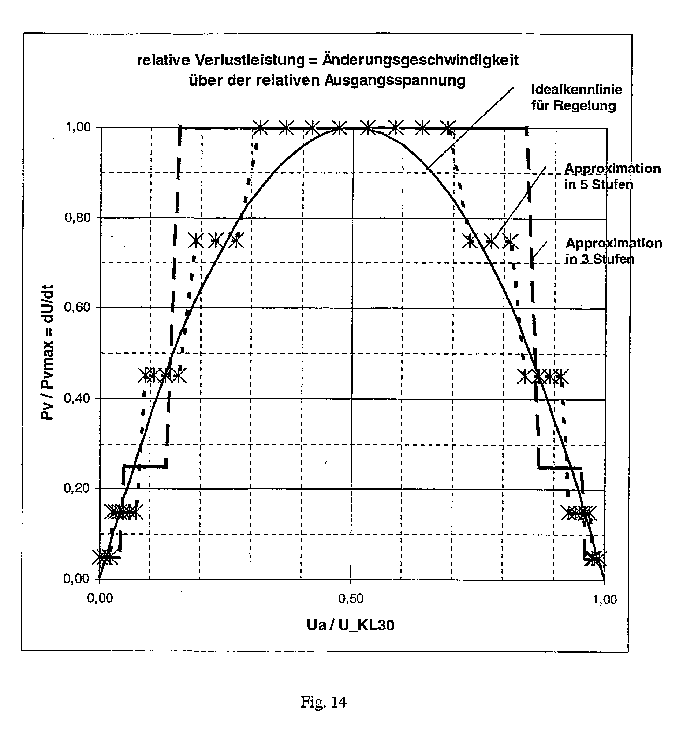

Fig. 14 verdeutlicht diesen Zusammenhang. Der Schalterwiderstand des Schaltmittels variiert bekanntlich über dem Schaltvorgang. Je nach Schalterwiderstand ergibt sich eine relative Ausgangsspannung Ua/Ubat. Fig. 14 zeigt nun die relative Verlustleistung Pv / Pvmax aufgetragen über diese relative Ausgangsspannung. Je größer die momentane Verlustleistung, desto schneller muß dieser Bereich verlassen werden. Das heißt, je höher die momentane relative Verlustleistung ist, desto höher muß die Schaltgeschwindigkeit sein. Die ideale Schaltgeschwindigkeit ist also proportional zur momentanen Verlustleistung. Es ergibt sich ein quadratische Idealkennlinie für die vorzugebende Steigung. Die Regelung entsprechend dieser Idealkennlinie ist jedoch recht aufwendig und wird daher vorzugsweise in mehreren Stufen approximiert. Die gestrichelte Kurve nähert die optimale Form über 3 Stufen an, die mit Sternen markierte Kurve über 5 Stufen. Die Steigung und damit die Schaltgeschwindigkeit wird also über den gesamten Schaltvorgang mit entsprechender Näherung gemäß der dabei momentan auftretenden relativen Verlustleistung gesteuert.

Für diese Aufgabe eignet sich eine Ansteuerung in zumindest drei Phasen, wobei die Steigung in der mittleren Phase deutlich höher ist als in der ersten und dritten Phase, wobei die Steigung auch innerhalb der Phasen nicht konstant sein muß, sondern auch stufenweise oder fließend angepasst werden kann. Entscheidend ist dabei einzig, dass in der mittleren Phase die Steigung insgesamt deutlich höher ist als in der ersten und dritten Phase. Entsprechend wird in den Phasen auch von einer maximalen Steigung gesprochen.

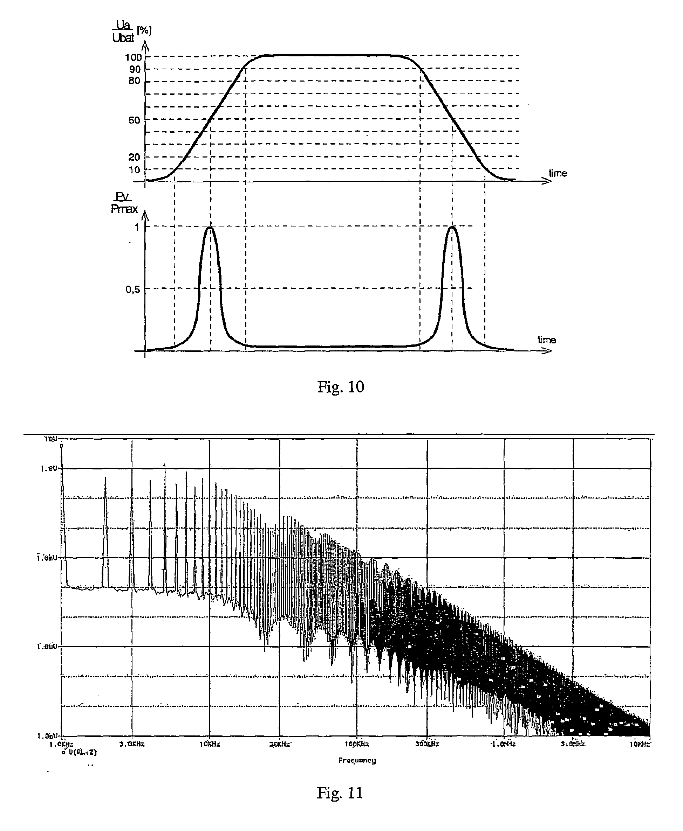

Dadurch kann das emittierte Spektrum in den hochfrequenten Bereichen reduziert werden ohne dabei die Schaltverluste signifikant zu erhöhen. Der daraus resultierende Verlauf der Ausgangsspannung im Schaltvorgang ist in Bild 10 prinzipiell dargestellt. Die Schaltzeit wie auch die Verlustleistung entsprechen annähernd dem in Fig. 8 gezeigten Beispiel zum Stand der Technik. Die Abflachung der Flanken in dem Anfangs- und Endbereich des Schaltvorgangs außerhalb des kritischen Verlustsbereichs führt aber bereits zu einer signifikanten Reduzierung der hochfrequenten Störungen, wie anhand der Fig. 9 und 11 erkannt werden kann.

Eine mögliche Realisierung dieses Schaltvorganges mit einem MOSFET-Schalter ist im Bild 6 gezeigt, wobei das Gate in Abhängigkeit von der Spannung am Lastelement im Schaltfall unterschiedlich stark bestromt wird und so die Steigung innerhalb des Schaltverlaufs gezielt angepasst wird. Im für die Verlustleistung kritischen mittleren Bereich des Schaltverlaufs wird daher der Strom und damit die Steigung höher als im Anfangs- und Endbereich. Durch steuerbare Stromquellen und entsprechende Steuerlogik können dabei die Übergänge sehr genau vorgegeben und ggfs. Eine sehr feine Anpassung realisiert werden. Die Versorgungsspannung ist hierbei als Klemme 30 (KL30), der im Kfz-Bereich üblichen Anschlussklemme für das Versorgungsbordnetz gekennzeichnet. Die Versorgungsspannung UH für die steuerbaren Stromquellen kann dabei geringfügig über den Potential an Klemme 30 liegen, um die zur Steuerung erforderliche Gate-Source-Spannung erbringen zu können.

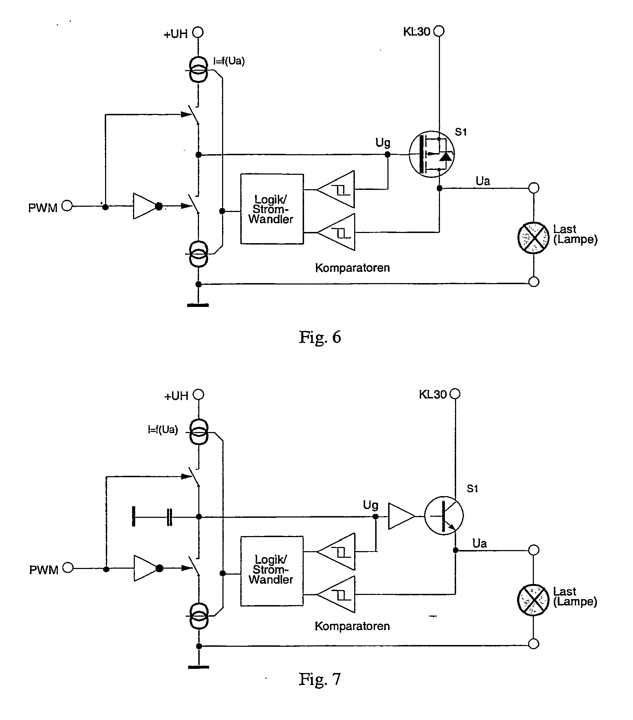

Ebenfalls denkbar ist die Realisierung mit einem bipolaren Leistungsschalter, wie in Fig. 7 gezeigt. Hierbei wird der Steuerstrom mit einem Kondensator integriert und diese Spannung mit einem Bufferverstärker auf die Basis des Bipolartransistors gesteuert:

Hierbei wird der Strom in das Gate und damit die Änderungsgeschwindigkeit des Schalttransistors in Abhängigkeit vom Zustand der Ausgangsspannung Ua und bzw. oder der Gatespannung Ug gesteuert.

In den Bereichen, in denen die Änderungsgeschwindigkeit und damit die Schaltgeschwindigkeit hoch ist, steht ein hoher Strom am Gate zur Verfügung. In den Bereichen, in denen die Änderungsgeschwindigkeit klein ist, steht lediglich ein kleiner Steuerstrom am Gate zur Verfügung.

Der Zustand der relevanten Signale Ua und Ug wird dabei vorzugsweise mit Komparatoren erfaßt und über einen Logik-Stromwandler ("logic to current converter") die Gateansteuerströme gesteuert.

Hoher Strom steht dabei zur Verfügung bei
1. Ug < Vp (ausgeschalteter Zustand)
2. Ug > KL30 +Vp (eingeschalteter Zustand)
3. Utrl < Ua < Utrh (währen der Schaltflanke)

Die Realisierung der Stromansteuerung kann entweder digital über 2 oder mehrere, geschaltete Stromquellen oder analog über modulierbare Stromquellen erfolgen.

Ein praktisches Ausführungsbeispiel sowie die dazugehörigen prinzipiellen Kurvenverläufe zeigt das folgende Bild 12.

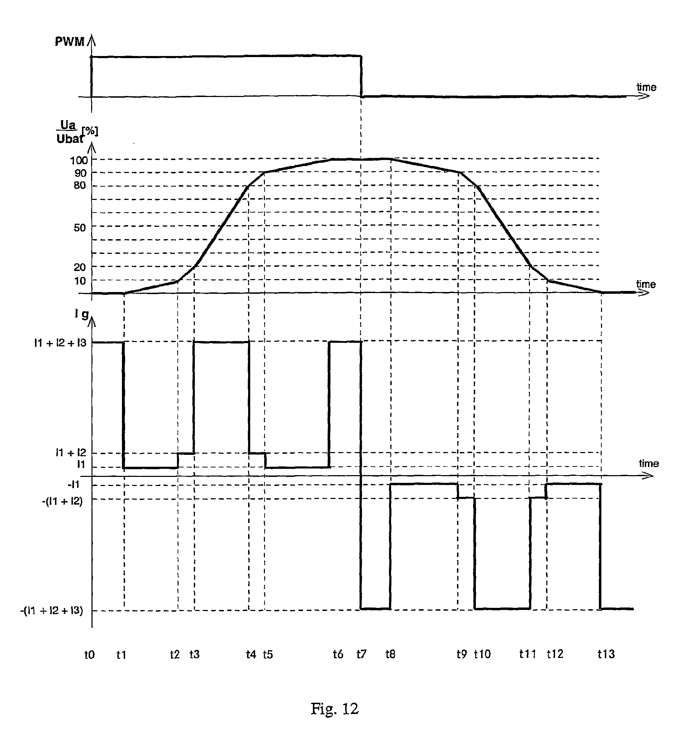

Der Zustand der Ansteuerspannung selbst wird mit dem Komparator Cm 1, der Ausgangsspannung Ua wird mit den Komparatoren Cmp2 und Cmp3 erfaßt und abhängig vom Schaltzustand der Komparatoren wird der.Strom in das Gate des Schalttransistors S 1 über die schaltbaren Stromquellen so gesteuert, daß
- der Strom im ein- und im ausgeschalteten Zustand (COND1) hoch ist, damit in diesen Bereichen, in denen die Spannung am Ausgang ja konstant ist (in Fig. 12 t0-t1, t6-t7, t7-t8) und damit keinen Einfluß auf das HF-Verhalten besteht, nicht die langsame Steigung verwendet sondern die Schaltzeit weiter verkürzt wird
- im Bereich der beginnenden Änderung der Versorgungsspannungen klein ist (keine der Bedingungen erfüllt in Fig. 12 t1-t2, t5-t6 usw.), da hier die hochfrequente Störungen auftreten, die Verlustleistung aber noch recht klein ist
- und während des Schaltvorgangs selbst (COND3) wieder hoch ist, weil die Verlustleistung hoch ist (in Fig. 12, t3-t4 und t10-t11)

Als Zwischenstufe (COND2) zwischen den Bereichen um die Versorgungsspannungen, also wenn die Ausgangsspannung beginnt, von Null Volt bzw. der Versorgungsspannung abzuweichen, ist im Schaltvorgang im vorliegenden Beispiel eine Phase mit leicht erhöhtem Strom eingefügt (t2-t3, t4-t5), um die Übergänge "weicher" zu gestalten. Die Übergänge zwischen den Phasen können zur besseren Abrundung des Stromverlaufes mit RC Gliedern bedämpft werden.

Länge, Höhe und Stufenanzahl der Ansteuerströme, sowie die genaue Lage der Komparatorschwellen können auf die entsprechenden Anforderungen der Schaltung angepaßt werden und sind im Idealfall parametrierbar.

Durch das Verfahren wird eine Reduktion der elektromagnetischen Abstrahlung in den Rundfunkfrequenzbereichen von pulsweitenmodulierten Ansteuerungen durch gezielte Beeinflussung der Schaltgeschwindigkeit erreicht.

Die Steuerung der Änderungsgeschwindigkeit des Schaltzustandes kann abhängig vom Zustand der Ausgangsspannung Ua und / oder der Steuerspannung Ug erfolgen und durch das PWM-Steuersignal die entsprechende Zeitsteuerung aktiviert werden.

Es erfolgt eine Steuerung des Ansteuerstromes des Schalters in Abhängigkeit von der Ausgangsspannung in der Art, daß die momentane Schaltgeschwindigkeit ein Optimum bildet zwischen Schaltverlustleistung und elektromagnetischer Abstrahlung.

Die Steuerung des Ansteuerstromes des Schalters erfolgt also zusätzlich in Abhängigkeit von der Gatespanung in der Art, daß die Schaltverzögerung klein bleibt. Dazu wird zu Beginn und Ende des Schaltvorgangs, noch bevor die Spannung am Lastelement sich ändert, die Spannung am Gate schnell mit einem hohen Strom aufgebaut, der sich noch nicht auf den Ausgang des Schaltmittels und damit auf die HF- Störungen auswirkt. Es wird also die Spannung am Steuereingang Ug des Schaltmittels überwacht (COND1). In der ersten Hauptphase wird solange ein Stromwert oberhalb des ersten Stromwertes zugeführt, wie die Spannung am Steuereingang kleiner ist (t0-t1) als eine vorgegebene Schwellenspannung (VT), die annähernd der Pinch-off-Spannung des jeweiligen Schaltmittels entspricht. Analog wird in der dritten (Haupt-)Phase wieder der Stromwert erhöht (t6-t7), wenn die Spannung am Steuereingang kleiner ALS die Differenz zwischen Versorgungsspannung (Ubat) und Schwellenspannung (VT) ist.

Die Steuerung des Ansteuerstromes kann entweder digital durch geschaltete Stromquellen oder analog durch modulierbare Stromquellen erfolgen.

Besonders vorteilhaft wird die Erfindung direkt in einen intelligenten Leistungsschalter integriert. Hierbei wirkt sich die Platz- und Kosteneinsparung besonders günstig aus.

Das Verfahren und die Schaltungsanordnung eignen sich insbesondere für die Ansteuerung von Lampen als im wesentlichen ohmsche Lasten, insbesondere für Kraftfahrzeuge.

## Patentansprüche

1. Verfahren zur Ansteuerung eines Lastelements, insbesondere eines im Wesentlichen ohmschen Lastelements (Lamp), mittels eines elektronischen Schaltelements (S1) im Laststromkreis, wobei die Spannung (Ua) am Lastelement mit einer maximal vorgegebenen Steigung gesteuert wird,
**dadurch gekennzeichnet, dass**
i) während des Schaltvorgangs mehrfach, vorzugsweise kontinuierlich die momentan auftretende Verlustleistung oder eine dazu abhängige Größe (Ua/Ubat) erfasst und die momentane Steigung (l1+l2+l3) in Abhängigkeit davon gesteuert wird,
ii) wobei die Ansteuerung derart erfolgt, dass im Bereich (t3-t4) hoher Verlustleistung die Spannung mit der maximal vorgegebenen Steigung angepasst wird, und in den Bereichen am Beginn (t1-t2) und Ende (t5-t6) des Schaltvorgangs mit einer Steigung kleiner als die maximale Steigung angepasst wird.

2. Verfahren nach Anspruch 1, **dadurch gekennzeichnet, dass** während des Schaltvorgangs das momentane Verhältnis aus Spannung am Lastelement zur Versorgungsspannung (Ua/Ubat) erfasst wird, zumindest für bestimmte Wertebereiche des Verhältnisses (Ua/Ubat) zugeordnete Steigungswerte vorgegeben werden und die Steigung während des Schaltvorgangs entsprechend angepasst wird.

3. Verfahren nach einem der vorangehenden Ansprüche, **dadurch gekennzeichnet, dass** das elektronische Schaltelement ein Transistorschalter (S1) mit einem aktiven Bereich ist und der erste und zweite Schwellwert derart vorgegeben sind, dass sie näherungsweise den aktiven Bereich eingrenzen und der Transistorschalter innerhalb dieses aktiven Bereichs mit der zweiten höheren Steigung gesteuert wird.

4. Verfahren nach einem der vorangehenden Ansprüche, **dadurch gekennzeichnet, dass** das elektronische Schaltelement ein Transistorschalter mit einem aktiven Bereich ist und der erste und zweite Schwellwert derart vorgegeben sind, dass
- eine vorgegebene maximale Verlustleistung pro Schaltvorgang einerseits und
- eine vorgegebene maximale elektromagnetische Störabstrahlung andererseits nicht überschritten werden.

5. Verfahren nach einem der vorangehenden Ansprüche, **dadurch gekennzeichnet, dass** die Spannung (Ua) am Lastelement im Verhältnis zur Versorgungsspannung (Ubat) als zur Verlustleistung proportionale Größe erfasst und als erster und zweiter Schwellwert entsprechende Spannungswerte vorgegeben sind, ab denen das Lastelement entsprechend der vorgegebenen maximalen Steigungen gesteuert wird.

6. Verfahren nach Anspruch 5, **dadurch gekennzeichnet, dass** der erste Schwellwert zwischen 5% und 30 % der Versorgungsspannung (Ubat) und der zweite Schwellwert zwischen 70% und 95 % liegen.

7. Verfahren nach Anspruch 6, **dadurch gekennzeichnet, dass** der erste Schwellwert bei ca. 15% und der zweite Schwellwert bei ca. 85% liegen.

8. Verfahren nach einem der vorangehenden Ansprüche, **dadurch gekennzeichnet, dass** zwischen der ersten und zweiten Phase zumindest eine Zwischenphase vorgesehen ist, in welcher die Spannung mit einer Steigung erhöht wird, die zwischen der maximalen Steigung in der ersten Phase und der maximalen Steigung in der zweiten Phase liegt.

9. Verfahren nach Anspruch 8, **dadurch gekennzeichnet, dass** der Schaltvorgang in drei Hauptphasen und zwei Zwischenphasen erfolgt, wobei
- in der ersten Hauptphase (t1-t2) die Ausgangsspannung bis zu einem ersten vorgegebenen Schwellwert (z. B. Ca. 10%) mit einer ersten Steigung (11) gesteuert wird,
- in der ersten Zwischenphase (t2-t3) die Ausgangsspannung bis zu einem zweiten vorgegebenen Schwellwert (z. B. Ca. 20%) mit einer zweiten Steigung (11+12) gesteuert wird,
- in der zweiten Hauptphase (t3-t4) die Ausgangsspannung bis zu einem dritten vorgegebenen Schwellwert (z. B. Ca. 80%) mit einer dritten Steigung (l1+l2+l3) gesteuert wird,
- in der zweiten Zwischenphase (t4-t5) die Ausgangsspannung bis zu einem zweiten vorgegebenen Schwellwert (z. B. Ca. 90%) mit der zweiten Steigung (l1+l2) gesteuert wird,
- in der dritten Hauptphase (t5-t6) die Ausgangsspannung bis zur Versorgungsspannung mit der ersten Steigung (l1) gesteuert wird, wobei die dritte Steigung (l1+l2+l3) größer ist als die zweite Steigung (l1+l2) und diese wiederum größer ist als die erste Steigung (l1).

10. Verfahren nach einem der vorangehenden Ansprüche, **dadurch gekennzeichnet, dass** zudem die Spannung am Steuereingang (Ug) des Schaltmittels überwacht (COND1) und in der ersten und dritten (Haupt-)Phase ein Stromwert (l1+l2+l3) oberhalb des ersten Stromwertes (l1) zugeführt wird, solange die Spannung am Steuereingang
- entweder kleiner ist (t0-t1) als eine vorgegebene Schwellenspannung (VT)
- oder größer (t6-t7) ist als die Differenz zwischen Versorgungsspannung (Ubat) und Schwellenspannung (VT).

11. Schaltungsanordnung zur Durchführung des Verfahrens nach einem der vorangehenden Ansprüche mit einem elektronischen Schaltelement (S1), welches an seinem Steuereingang (Ug) eine Steuereinheit und am Lastausgang das Lastelement aufweist, wobei die Steuereinheit den Schaltzustand des Schaltelements erfasst (Cmp1-3) und in Abhängigkeit von einem Ansteuersignal und dem Schaltzustand das Schaltelement derart ansteuert, dass die Spannung am Lastausgang in drei Phasen mit begrenzten Steigung gesteuert wird, wobei die Steigung in der zweiten, mittleren Phase betragsmäßig größer ist als die Steigung in den anderen Phasen.

12. Schaltungsanordnung nach Anspruch 11, **dadurch gekennzeichnet, dass** am Steuereingang des Schaltelements stromgesteuert ist, indem in Abhängigkeit vom Ansteuersignal und dem Schaltzustand am Steuereingang
- in der ersten Phase ein erster Stromwert (l1),
- in der zweiten Phase ein zweiter, höherer Stromwert (l1+l2+l3) und
- in der dritten Phase ein dritter Stromwert (l1) zugeführt wird, welcher kleiner als der zweite Stromwert ist.

13. Schaltungsanordnung nach Anspruch 12, **dadurch gekennzeichnet, dass** zumindest zwei Stromquellenschaltungen (l1, l2, l3) am Steuereingang vorgesehen sind, welche wiederum in Abhängigkeit vom Schaltzustand des Schaltelements im Laststromkreis gesteuert werden.

14. Schaltungsanordnung nach einem der vorangehenden Ansprüche 11 bis 13, **dadurch gekennzeichnet, dass** am Steuereingang des Schaltmittels ein Glättungselement, beispielsweise ein RC-Tiefpass vorgesehene ist, welcher die Flanken beim Umschalten zwischen den Stromwerten abrundet.

15. Schaltungsanordnung nach einem der vorangehenden Ansprüche 11 bis 14, **dadurch gekennzeichnet, dass** zudem die Spannung am Steuereingang (Ug) des Schaltmittels überwacht (COND1) und in der ersten und dritten Phase ein Stromwert oberhalb des ersten Stromwertes zugeführt wird, solange die Spannung am Steuereingang
- entweder kleiner ist (t0-t1) als eine vorgegebene Schwellenspannung (VT)
- oder größer (t6-t7) ist als die Differenz zwischen Versorgungsspannung (Ubat) und Schwellenspannung (VT).

16. Verwendung des Verfahrens oder der Schaltungsanordnung nach einem der vorangehenden Ansprüche für die pulsweitenmodulierte Ansteuerung eines im Wesentlichen ohmschen Lastelements, insbesondere in Kraftfahrzeugen.

17. Verwendung des Verfahrens oder der Schaltungsanordnung nach einem der vorangehenden Ansprüche für die pulsweitenmodulierte Ansteuerung von Lampen im Dauerlichtbetrieb in einem Frequenzbereich oberhalb 100 Hertz, insbesondere in Kraftfahrzeugen.

## Claims

1. A method for triggering a load element, in particular an essentially ohmic load element (Lamp) by means of an electronic switching element (S1) in the load current circuit, wherein the voltage (Ua) on the load element is controlled with a maximum specified ascending gradient
**characterized in that**
i) during the switching procedure, the dissipated power currently occurring or a value (Ua/Ubat) which depends on it, is recorded several times, preferably continuously, and the current ascending gradient (l1+l2+l3) is controlled dependent on this
ii) wherein the triggering is accomplished in such a manner that in the range (t3-t4) of high power dissipation, the voltage is adapted with the maximum specified ascending gradient, and in the ranges at the beginning (t1-t2) and the end (t5-t6) of the switching procedure, it is adapted with an ascending gradient which is smaller than the maximum gradient.

2. A method according to claim 1, **characterized in that** during the switching procedure, the current ratio between the voltage on the load element and the supply voltage (Ua/Ubat) is recorded, assigned ascending gradient values are specified at least for certain value ranges of the ratio (Ua/Ubat), and the ascending gradient is adapted accordingly during the switching procedure.

3. A method according to any one of the preceding claims **characterized in that** the electronic switching element is a transistor switch (S1) with an active range, and the first and second threshold value are specified in such a manner that they approximately localise the active range, and the transistor switch is controlled with the second higher ascending gradient within this active range.

4. A method according to any one of the preceding claims, **characterized in that** the electronic switching element is a transistor switch with an active range, and the first and second threshold values are specified in such a manner that
- a specified maximum power dissipation for each switching procedure on the one hand, and
- a specified maximum electro-magnetic interference beam on the other are not exceeded.

5. A method according to any one of the preceding claims, **characterized in that** the voltage (Ua) on the load element in relation to the supply voltage is recorded as a value which is proportionate to the power dissipation, and corresponding voltage values are specified as the first and second threshold value, at and above which the load element is controlled according to the specified maximum ascending gradients.

6. A method according to claim 5, **characterized in that** the first threshold value lies between 5% and 30% of the supply voltage (Ubat) and the second threshold value lies between 70% and 95%.

7. A method according to claim 6, **characterized in that** the first threshold value lies at approx. 15%, and the second threshold value lies at approx. 85%.

8. A method according to any one of the preceding claims, **characterized in that** between the first and the second phase, at least one interim phase is provided, in which the voltage is increased by an ascending gradient which lies between the maximum ascending gradient in the first phase and the maximum ascending gradient in the second phase.

9. A method according to claim 8, **characterized in that** the switching procedure is accomplished in three main phases and two interim phases, wherein:
- in the first main phase (t1-t2), the output voltage is controlled up to a first specified threshold value (e.g. approx. 10%) with a first ascending gradient (l1)
- in the second interim phase (t2-t3), the output voltage is controlled up to a second specified threshold value (e.g. approx. 20%) with a second ascending gradient (l1+l2)
- in the second main phase (t3-t4), the output voltage is controlled up to a third specified threshold value (e.g. approx. 80%) with a third ascending gradient (l1+l2+l3)
- in the second interim phase (t4-t5), the output voltage is controlled up to a second specified threshold value (e.g. approx. 90%) with a second ascending gradient (l1+l2)
- in the third main phase (t5-t6), the output voltage is controlled up to the supply voltage with the first ascending gradient (l1), wherein the third ascending gradient (l1+l2+l3) is greater than the second ascending gradient (l1+l2) and this is in turn greater than the first ascending gradient (l1).

10. A method according to any one of the preceding claims, **characterized in that** furthermore, the voltage at the control input (Ug) of the switching means is monitored (COND1) and in the first and third (main) phase, a current value (l1+l2+l3) above the first current value (11) is supplied until the voltage on the control input:
- is either lower (t0-t1) than a specified threshold voltage (VT)
- or is higher (t6-t7) than the difference between the supply voltage (Ubat) and the threshold voltage (VT).

11. A circuit arrangement for implementing the method according to any one of the preceding claims with an electronic switching element (S1) which comprises on its control input (Ug) a control unit and on the load output the load element, wherein the control unit records the switching state of the switching element (Cmp1-3) and depending on a triggering signal and the switching sate, triggers the switching element in such a manner that the voltage on the load output is controlled in three phases with a limited ascending gradient, wherein the ascending gradient in the second, middle phase is greater in value than the ascending gradient in the other phases.

12. A circuit arrangement according to claim 11, **characterized in that** on the control input of the switching element, it is current controlled, whereby depending on the triggering signal and the switching state on the control input:
- a first current value (11) is supplied in the first phase
- a second, higher current value (l1+l2+l3) is supplied in the second phase, and
- a third current value (11) is supplied in the third phase, which is less than the second current value.

13. A circuit arrangement according to claim 12, **characterized in that** at least two current source circuits (l1, l2, l3) are provided on the control input, which in turn are controlled depending on the switching state of the switching element in the load current circuit.

14. A circuit arrangement according to any one of the preceding claims 11 to 13, **characterized in that** on the control input of the switching means, a smoothing element such as an RC low-pass, is provided, which rounds off the edges when switching over between the current values.

15. A circuit arrangement according to any one of the preceding claims 11 to 14, **characterized in that** furthermore, the voltage on the control input (Ug) of the switching means is monitored (COND1) and in the first and third phase, a current value above the first current value is supplied until the voltage on the control input:
- is either lower (t0-t1) than a specified threshold voltage (VT)
- or higher (t6-t7) than the difference between the supply voltage (Ubat) and the threshold voltage (VT).

16. The use of the method or circuit arrangement according to any one of the preceding claims for the pulse width modulated triggering of an essentially ohmic load element, particularly in motor vehicles.

17. The use of the method or circuit arrangement according to any one of the preceding claims for the pulse width modulated triggering of lamps in steady burning mode in a frequency range above 100 hertz, particularly in motor vehicles.

## Revendications

1. Procédé pour le pilotage d'un élément de charge, en particulier d'un élément de charge essentiellement ohmique (lampe), au moyen d'un élément de commutation électronique (S1) dans le circuit de charge, la tension (Ua) étant commandée avec une pente maximale spécifiée,
**caractérisé en ce que**
i) pendant le processus de commutation, la puissance dissipée apparaissant momentanément ou une grandeur en dépendant (Ua/Ubat) est saisie de multiples fois, de préférence continûment, et la pente momentanée (l1+l2+l3) est commandée en fonction de celle-ci,
ii) le pilotage étant réalisé de telle sorte que, dans la plage (t3-t4) de puissance dissipée élevée, la tension est ajustée avec la pente maximale spécifiée et, dans les plages au début (t1-t2) et à la fin (t5-t6) du processus de commutation, la tension est ajustée avec une pente plus faible que la pente maximale.

2. Procédé selon la revendication 1, **caractérisé en ce que**, pendant le processus de commutation, le rapport momentané de la tension de l'élément de charge et de la tension d'alimentation (Ua/Ubat) est saisi, des valeurs de pente dédiées sont spécifiées au moins pour des plages de valeurs données du rapport (Ua/Ubat) et la pente est ajustée de façon correspondante pendant le processus de commutation.

3. Procédé selon l'une des revendications précédentes, **caractérisé en ce que** l'élément de commutation électronique est un interrupteur à transistor (S1) avec une plage active et **en ce que** la première et la deuxième valeurs de seuil sont spécifiées de telle sorte qu'elles délimitent la plage active de façon approximative et que l'interrupteur à transistor est commandé au sein de cette plage active avec la deuxième pente la plus élevée.

4. Procédé selon l'une des revendications précédentes, **caractérisé en ce que** l'élément de commutation électronique est un interrupteur à transistor avec une plage active et **en ce que** la première et la deuxième valeurs de seuil sont spécifiées de telle sorte
- qu'une puissance dissipée maximale spécifiée par processus de commutation, d'une part, et
- qu'un rayonnement parasite électromagnétique maximal spécifié, d'autre part, ne peuvent pas être dépassés.

5. Procédé selon l'une des revendications précédentes, **caractérisé en ce que** la tension (Ua) de l'élément de charge par rapport à la tension d'alimentation (Ubat) est saisie comme grandeur proportionnelle à la puissance dissipée et **en ce que** des valeurs de tension correspondantes sont spécifiées comme première et deuxième valeurs de seuil à partir desquelles l'élément de charge est commandé de façon correspondante aux pentes maximales spécifiées.

6. Procédé selon la revendication 5, **caractérisé en ce que** la première valeur de seuil se trouve entre 5% et 30 % et la deuxième valeur de seuil se trouve entre 70% et 95 % de la tension d'alimentation (Ubat).

7. Procédé selon la revendication 6, **caractérisé en ce que** la première valeur de seuil se trouve environ vers 15% et la deuxième valeur de seuil environ vers 85%.

8. Procédé selon l'une des revendications précédentes, **caractérisé en ce que,** entre la première et la deuxième phase, au moins une phase intermédiaire est prévue, au cours de laquelle la tension est augmentée avec une pente se trouvant entre la pente maximale dans la première phase et la pente maximale dans la deuxième phase.

9. Procédé selon la revendication 8, **caractérisé en ce que** le processus de commutation a lieu en trois phases principales et deux phases intermédiaires,
- la tension de sortie étant commandée jusqu'à une première valeur de seuil spécifiée (par exemple environ 10 %), avec une première pente (l1), au cours de la première phase principale (t1-t2),
- la tension de sortie étant commandée jusqu'à une deuxième valeur de seuil spécifiée (par exemple environ 20 %), avec une deuxième pente (l1+l2), au cours de la première phase intermédiaire (t2-t3),
- la tension de sortie étant commandée jusqu'à une troisième valeur de seuil spécifiée (par exemple environ 80 %), avec une troisième pente (l1+l2+l3), au cours de la deuxième phase principale (t3-t4),
- la tension de sortie étant commandée jusqu'à une deuxième valeur de seuil spécifiée (par exemple environ 90 %), avec la deuxième pente (l1+l2), au cours de la deuxième phase intermédiaire (t4-t5),
- la tension de sortie étant commandée jusqu'à la tension d'alimentation avec la première pente (l1), la troisième pente (l1+l2+l3) étant plus importante que la deuxième pente (l1+l2) et celle-ci étant à son tour plus importante que la première pente (l1), au cours de la troisième phase principale (t5-t6).

10. Procédé selon l'une des revendications précédentes, **caractérisé en ce que,** en outre, la tension à l'entrée de commande (Ug) du moyen de commutation est surveillée (COND1) et, au cours des première et troisième phases (principales), une valeur de courant (l1+l2+l3) supérieure à la première valeur de courant (l1) est amenée, tant que la tension à l'entrée de commande
- soit est plus faible (t0-t1) q'une tension de seuil spécifiée (VT),
- soit est plus élevée (t6-t7) que la différence entre la tension d'alimentation (Ubat) et la tension de seuil (VT).

11. Agencement de circuit pour l'exécution du procédé selon l'une des revendications précédentes avec un élément de commutation électronique (S1), lequel présente à son entrée de commande (Ug) une unité de commande et à la sortie de charge l'élément de charge, l'unité de commande saisissant l'état de commutation de l'élément de commutation (Cmp1-3) et, en fonction d'un signal d'excitation et de l'état de commutation, pilote l'élément de commutation de telle sorte que la tension à la sortie de charge est commandée en trois phases avec pente limitée, la pente étant de valeur plus importante dans la deuxième phase, intermédiaire, que la pente dans les autres phases.

12. Agencement de circuit selon la revendication 11, **caractérisé en ce que**, à l'entrée de commande de l'élément de commutation, on commande en courant, en amenant à l'entrée de commande, en fonction du signal d'excitation et de l'état de commutation,
- une première valeur de courant (l1), dans la première phase,
- une deuxième valeur de courant (l1+l2+l3), plus élevée, dans la deuxième phase, et
- une troisième valeur de courant (l1), laquelle est plus faible que la deuxième valeur de courant, dans la troisième phase.

13. Agencement de circuit selon la revendication 12, **caractérisé en ce qu'**au moins deux circuits de source de courant (l1, l2, l3) sont prévus à l'entrée de commande, lesquels sont commandés à leur tour en fonction de l'état de commutation de l'élément de commutation dans le circuit de charge.

14. Agencement de circuit selon l'une des revendications précédentes 11 à 13, **caractérisé en ce que**, à l'entrée de commande du moyen de commutation, un élément de filtrage, par exemple un passe-bas RC est prévu, lequel arrondit les pentes lors de la commutation entre les valeurs de courant.

15. Procédé selon l'une des revendications précédentes 11 à 14, **caractérisé en ce que**, en outre, la tension à l'entrée de commande (Ug) du moyen de commutation est surveillée (COND1) et, au cours des première et troisième phases, une valeur de courant supérieure à la première valeur de courant est amenée, tant que la tension à l'entrée de commande
- soit est plus faible (t0-t1) qu'une tension de seuil spécifiée (VT),
- soit est plus élevée (t6-t7) que la différence entre la tension d'alimentation (Ubat) et la tension de seuil (VT).

16. Utilisation du procédé ou de l'agencement de circuit selon l'une des revendications précédentes pour le pilotage par modulation de largeur d'impulsions d'un élément de charge essentiellement ohmique, en particulier sur des véhicules à moteur.

17. Utilisation du procédé ou de l'agencement de circuit selon l'une des revendications précédentes pour le pilotage par modulation de largeur d'impulsions de lampes en fonctionnement continu dans une gamme de fréquence supérieure à 100 Hertz, en particulier sur des véhicules à moteur.
